# EUROPÄISCHE PATENTSCHRIFT

(11) **EP 0 924 759 B1**
(45) Veröffentlichungstag und Bekanntmachung des Hinweises auf die Patenterteilung: **21.03.2001**
(21) Anmeldenummer: 98123049.3
(22) Anmeldetag: 08.12.1998
(51) Int. Cl.: H01L 21/68

(54) **Verfahren zur Montage und Demontage einer Halbleiterscheibe und Stoffmischung, die zur Durchführung des Verfahrens geeignet ist**
Method for mounting and demounting a semiconductor wafer, and material suited for this method
Procédé pour le montage et démontage d'une plaquette semiconductrice, et matériau adapté à ce procédé

(30) Priorität: 18.12.1997 DE 19756614
(43) Veröffentlichungstag der Anmeldung: 23.06.1999
(73) Patentinhaber: Wacker Siltronic Gesellschaft für Halbleitermaterialien Aktiengesellschaft, 84489 Burghausen (DE)
(72) Erfinder: Rurlaender, Robert, 84553 Halsbach (DE); Franze, Norbert, 84508 Burgkirchen (DE); Mangs, Franz, 84529 Tittmoning (DE); Schnegg, Anton, Dr., 84489 Burghausen (DE)
(74) Vertreter: Rimböck, Karl-Heinz, Dr.

(56) Entgegenhaltungen:
- EP-A- 0 601 615
- DE-A- 1 514 864
- FR-A- 2 384 589
- PATENT ABSTRACTS OF JAPAN vol. 098, no. 003, 27. Februar 1998 (1998-02-27) & JP 09 286967 A (THE INCTEC INC), 4. November 1997 (1997-11-04)

## Beschreibung

Gegenstand der Erfindung ist ein Verfahren zur Montage und Demontage einer Halbleiterscheibe, wobei durch eine Stoffmischung zwischen der Halbleiterscheibe und einer Trägerplatte eine temperaturabhängig klebende und aushärtende Verbindung geschaffen wird, und die Stoffmischung ein Kolophoniumharz enthält, das chemisch modifiziert und verestert ist, und die ausgehärtete Verbindung nach einer Politur der Halbleiterscheibe wieder gelöst wird. Gegenstand der Erfindung ist außerdem eine in Wasser gelöste und in einem getrockneten Zustand temperaturabhängig klebende und aushärtende Stoffmischung, die ein Kolophoniumharz enthält, das chemisch modifiziert und verestert ist, und zur Durchführung des Verfahrens geeignet ist.

Zur Politur einer Vorderseite einer Halbleiterscheibe wird die Halbleiterscheibe mit der Rückseite auf einer Trägerplatte fixiert. Die Verbindung zwischen der Halbleiterscheibe und der Trägerplatte wird mittels einer dünnen Schicht eines temperaturabhängig klebenden und aushärtenden Klebstoffes geschaffen. An den Klebstoff sind außerordentliche Anforderungen zu stellen, damit die Politur erfolgreich ist. Die Trägerplatte muß gleichmäßig mit dem Klebstoff beschichtet werden können. Die Klebewirkung des Klebstoffes muß auf einen engen Temperaturbereich begrenzt sein. Der Klebstoff muß unter den Bedingungen der Politur fest sein und bleiben, so daß die Halbleiterscheibe auf der Trägerplatte fixiert bleibt. Die Verwendung des Klebstoffes darf sich insbesondere nicht nachteilig auf die Form der polierten Halbleiterscheibe auswirken. Die Oberfläche der polierten Halbleiterscheibe muß möglichst eben sein. Nach der Politur sollte der Klebstoff ohne besonderen Aufwand von der Trägerplatte und der Halbleiterscheibe wieder entfernt werden können. Schließlich sollte der Klebstoff auch keine Stoffe, insbesondere Metallspuren abgeben, die die Halbleiterscheibe verunreinigen.

Kolophoniumharze und Derivate davon sind dafür bekannt, eine Temperaturabhängige Klebewirkung zu besitzen. Bisher konnte jedoch noch kein darauf basierender Klebstoff angegeben werden, der die genannten Anforderungen in vollem Umfang erfüllen kann.

Gegenstand der Erfindung ist ein Verfahren zur Montage und Demontage einer Halbleiterscheibe, wobei durch eine Stoffmischung zwischen der Halbleiterscheibe und einer Trägerplatte eine temperaturabhängig klebende und aushärtende Verbindung geschaffen wird, und die Stoffmischung ein Kolophoniumharz enthält, das chemisch modifiziert und verestert ist, und die ausgehärtete Verbindung nach einer Politur der Halbleiterscheibe wieder gelöst wird, dadurch gekennzeichnet, daß die ausgehärtete Verbindung mit Wasser gelöst wird und die Stoffmischung ein Amin der Formel NR¹R²R³ enthält, das das Kolophoniumharz verseift, wobei mindestens einer der Reste R¹, R² und R³ der Rest eines aliphatischen Alkohols ist und der Siedepunkt des Amins bei einem Druck von 1000 mbar (1 bar = 10⁵Pa) größer als 150 °C. Gegenstand der Erfindung ist darüber hinaus die Stoffmischung, die dadurch gekennzeichnet ist, daß sie ein Amin der Formel NR¹R²R³ enthält, das das Kolophoniumharz verseift, wobei mindestens einer der Reste R¹, R² und R³ der Rest eines aliphatischen Alkohols ist, und der Siedepunkt des Amins bei einem Druck von 1000 mbar größer als 150 °C ist.

Die Erfindung zeichnet sich insbesondere dadurch aus, daß beim Abmischen und Erhitzen der Stoffmischung keine brennbaren organischen Lösemittel oder gesundheitsschädlichen Gase frei werden, und gegen solche Substanzen gerichtete, aufwendige Sicherheitsvorkehrungen unterbleiben können. Die Stoffmischung kann zudem durch Erhitzen auf vergleichsweise niedrige Temperaturen in einen klebenden Zustand versetzt werden und ist auch in ausgehärtetem Zustand mit Wasser vollständig zu lösen. Darüber hinaus hinterläßt das Verfahren keine Welligkeit im Submikrometer-Bereich ("waviness") auf der Oberfläche der polierten Halbleiterscheibe.

Die Stoffmischung enthält chemisch modifiziertes und verestertes Kolophoniumharz. Dieses Produkt ist auch kommerziell erhältlich. Das Kolophoniumharz wird vorzugsweise durch

Vakuumdestillation aus Roh-Tallöl ("crude tall oil") gewonnen. Besonders bevorzugt ist, eine doppelt vakuumdestillierte Fraktion des Roh-Tallöls mit enger Molekulargewichtsverteilung für die Stoffmischung zu verwenden. Das auf diese Weise gewonnene Kolophoniumharz ("tall oil rosin") wird chemisch modifiziert und verestert. Bevorzugt ist, daß das Kolophoniumharz durch Reaktion mit einer Verbindung chemisch modifiziert wird, die aus einer Gruppe ausgewählt ist, die Maleinsäure, Maleinsäureanhydrid und Fumarsäure umfaßt. Anschließend wird das modifizierte Harz vorzugsweise mit einem Alkohol verestert, der aus einer Gruppe ausgewählt ist, die Glycerin und Pentaerythrit umfaßt. Das chemisch modifizierte und veresterte Kolophoniumharz sollte eine Säurezahl von 50 bis 250, bevorzugt 100 bis 140 [mg KOH/g Harz], und einen Erweichungspunkt von 60 bis 180 °C, bevorzugt 90 bis 140 °C aufweisen. Besonders bevorzugt wird ein Harz von Arizona Chemicals, Schweden, eingesetzt, das unter dem Handelsnamen Bergvik M-1XX kommerziell erhältlich ist, wobei XX eine laufende Chargennummer, beispielsweise 00, 01 etc. ist.

Gemäß der Erfindung wird mit dem modifizierten und veresterten Kolophoniumharz eine Stoffmischung hergestellt, die ein Amin der Formel NR¹R²R³ enthält, wobei mindestens einer der Reste R¹, R² und R³ der Rest eines aliphatischen Alkohols ist, und der Siedepunkt des Amins bei einem Druck von 1000 mbar größer als 150 °C ist. Besonders bevorzugt ist die Verwendung von Triethanolamin. Besonders geeignet sind ferner: Triisopropanolamin, Diisopropanolamin und Diethanolamin. Das Kolophoniumharz wird in Gegenwart des in Wasser gelösten Amins verseift; die Harzseife geht dabei in der wässrigen Phase in Lösung.

Die Stoffmischung hat gemäß einer besonders bevorzugten Formulierung die folgende Zusammensetzung:
15 bis 20 Gew.-% chemisch modifiziertes und verestertes Kolophoniumharz;
5 bis 10 Gew.-% Triethanolamin;
bis zu 2 Gew.-% nicht-ionisches Tensid, insbesondere Nonylphenolpolyether, das als Weichmacher wirkt;
bis zu 10 Gew.-% alkoholischer Lösevermittler, insbesondere Isopropanol;
bis zu 0,05 Gew.-% eines Farbstoffs, insbesondere Kristallviolett, Fluoreszenzfarbstoffe wie Rhodamin B und Eosin, und intensiv färbende wasserlösliche Lebensmittelfarbstoffe wie Malachitgrün; und
Wasser in einer die Summe der Mengenangaben zu 100 Gew.-% ergänzenden Menge.

Die Viskosität der Stoffmischung ist darauf abgestimmt, Trägerplatten mit der Stoffmischung homogen beschichten zu können. Nach der Beschichtung trocknet die Stoffmischung zu einer temperaturabhängig klebenden und aushärtenden Masse. Die Klebewirkung der Masse entfaltet sich nur innerhalb eines schmalen Temperaturbereiches (Haftzone, "sticking zone") von vorzugsweise 45 bis 85 °C. Die Klebewirkung läßt wie bei einem Schmelzkleber nach, wenn die Masse über eine obere Temperatur der Haftzone erhitzt wird. Zum Herstelllen einer aushärtenden Verbindung zwischen einer Halbleiterscheibe und der Trägerplatte wird die Trägerplatte auf eine Temperatur erhitzt, die innerhalb der Haftzone liegt, und eine oder mehrere Halbleiterscheiben auf die Trägerplatte gelegt. Beim Abkühlen der Trägerplatte härtet die Masse aus und schafft damit eine feste Verbindung zwischen der Halbleiterscheibe und der Trägerplatte. Diese Verbindung bleibt auch unter den während einer Politur üblicherweise herrschenden Temperatur-Bedingungen von 30 bis 50 °C fest. Nach der Politur der Halbleiterscheibe wird die Verbindung zwischen der Halbleiterscheibe und der Trägerplatte wieder gelöst. Dies geschieht dadurch, daß man Wasser, das vorzugsweise eine Temperatur von 15 bis 25 °C besitzt, einwirken läßt. Wasser ist in der Lage, die Reste der Stoffmischung rückstandslos von der Halbleiterscheibe und der Trägerplatte lösen zu können.

Die Herstellung der Stoffmischung wird an nachfolgenden Beispielen deutlich.

### Beispiel 1)

Zu 35,74 kg Bergvik M-106 Harz wurden unter Rühren bei Raumtemperatur nacheinander 139,26 kg deionisiertes Wasser, 14,74 kg Triethanolamin (80 Gew.-%), 4,52 kg Nonylphenolpolyether, 19,64 kg reines Isopropanol und 0,1 kg Kristallviolett gegeben. Nach dem Auflösen der Feststoffe wurde der Ansatz durch einen 5 µm Beutelfilter filtriert und in Kanister abgefüllt.

Die Viskosität der Lösung betrug 22 mm²/s bei 25 °C . Die Haftzone der getrockneten Stoffmischung lag in einem Temperaturbereich von 49 bis 72 °C.

### Beispiel 2)

- Zu 35,74 kg Bergvik M-106 Harz wurden unter Rühren bei Raumtemperatur nacheinander 138,50 kg deionisiertes Wasser, 14,4 kg Triethanolamin (80 Gew.-%), 4,50 kg Nonylphenolpolyether, 19,7 kg reines Isopropanol und 0,1 kg Malachitgrün gegeben. Nach dem Auflösen der Feststoffe wurde der Ansatz durch einen 5 µm Beutelfilter filtriert und in Kanister abgefüllt. Die Viskosität der Lösung betrug 22 mm²/s bei 25 °C. Die Haftzone der getrockneten Stoffmischung lag in einem Temperaturbereich von 60 bis 80 °C.

### Beispiel 3)

Zu 66,28 kg Bergvik M-106 Harz wurden unter Rühren bei Raumtemperatur nacheinander 276,50 kg deionisiertes Wasser, 23,12 kg Triethanolamin (80 Gew.-%), 8,42 kg Nonylphenolpolyether, 25 kg reines Isopropanol und 0,185 kg Rhodamin B gegeben. Nach dem Auflösen der Feststoffe wurde der Ansatz durch einen 5 µm Beutelfilter filtriert und in Kanister abgefüllt. Die Viskosität der Lösung betrug 22 mm²/s bei 25 °C. Die Haftzone der getrockneten Stoffmischung lag in einem Temperaturbereich von 66 bis 79 °C.

## Patentansprüche

1. Verfahren zur Montage und Demontage einer Halbleiterscheibe, wobei durch eine Stoffmischung zwischen der Halbleiterscheibe und einer Trägerplatte eine temperaturabhängig klebende und aushärtende Verbindung geschaffen wird, und die Stoffmischung ein Kolophoniumharz enthält, das chemisch modifiziert und verestert ist, und die ausgehärtete Verbindung nach einer Politur der Halbleiterscheibe wieder gelöst wird, dadurch gekennzeichnet, daß die ausgehärtete Verbindung mit Wasser gelöst wird und die Stoffmischung ein Amin der Formel NR¹ R²R³ enthält, das das Kolophoniumharz verseift, wobei mindestens einer der Reste R¹, R² und R³ der Rest eines aliphatischen Alkohols ist, und der Siedepunkt des Amins bei einem Druck von 10⁵Pa (1000 mbar) größer als 150 °C ist.

2. Verfahren nach Anspruch 1, dadurch gekennzeichnet, daß die Stoffmischung in einem getrockneten Zustand eine Klebewirkung besitzt, die sich nur innerhalb eines Temperaturbereiches von 45 bis 85 °C entfaltet.

3. Verfahren nach Anspruch 1 oder Anspruch 2, dadurch gekennzeichnet, daß die ausgehärtete Verbindung mit Wasser gelöst wird, ohne daß Rückstände der Verbindung auf der Trägerplatte oder der Halbleiterscheibe bleiben.

4. In Wasser gelöste Stoffmischung, die in einem getrockneten Zustand temperaturabhängig klebt und aushärtet, und ein Kolophoniumharz enthält, das chemisch modifiziert und verestert ist, dadurch gekennzeichnet, daß die Stoffmischung ein Amin der Formel NR¹R²R³ enthält, das das Kolophoniumharz verseift, wobei mindestens einer der Reste R¹, R² und R³ der Rest eines aliphatischen Alkohols ist, und der Siedepunkt des Amins bei einem Druck von 10⁵Pa (1000 mbar) größer als 150 °C ist.

5. Stoffmischung nach Anspruch 4, dadurch gekennzeichet, daß das Amin aus einer Gruppe ausgewählt ist, die Triethanolamin, Triisopropanolamin, Diisopropanolamin und Diethanolamin umfaßt.

6. Stoffmischung nach Anspruch 4 oder Anspruch 5, dadurch gekennzeichnet, daß das Kolophoniumharz durch Reaktion mit einer Verbindung chemisch modifiziert ist, die aus einer Gruppe ausgewählt ist, die Maleinsäure, Maleinsäureanhydrid und Fumarsäure umfaßt.

7. Stoffmischung nach einem der Ansprüche 4 bis 6, dadurch gekennzeichnet, daß das Kolophoniumharz mit einem Alkohol verestert ist, der aus einer Gruppe ausgewählt ist, die Glycerin und Pentaerythrit umfaßt.

8. stoffmischung nach einem der Ansprüche 4 bis 7, gekennzeichnet durch folgende Zusammensetzung:
15 bis 20 Gew.-% chemisch modifiziertes und verestertes Kolophoniumharz;
5 bis 10 Gew.-% Triethanolamin;
bis zu 2 Gew.-% nicht-ionisches Tensid;
bis zu 10 Gew.-% alkoholischer Lösevermittler;
bis zu 0,05 Gew.-% eines Farbstoffs; und
Wasser in einer die Summe der Mengenangaben zu 100 Gew.-% ergänzenden Menge.

## Claims

1. Method of mounting and demounting a semiconductor wafer, in which a temperature-dependently adhesive and curing joint is provided by a substance mixture between the semiconductor wafer and a carrier plate and the substance mixture contains a colophonium resin which is chemically modified and esterified, and the cured joint is released again after polishing the semiconductor wafer, characterized in that the cured joint is released with water and the substance mixture contains an amine of the formula NR¹R²R³ which saporifies the colophonium resin, at least one of the radicals R¹, R² and R³ being the radical of an aliphatic alcohol, and the boiling point of the amine being higher than 150°C at a pressure of 10⁵ Pa (1000 mbar).

2. Method according to Claim 1, characterized in that the substance mixture has, in a dried state, an adhesive action which develops only within a temperature range of 45 to 85°C.

3. Method according to Claim 1 or 2, characterized in that the cured joint is released with water without residues from the joint remaining on the carrier plate or the semiconductor wafer.

4. Water-dissolved substance mixture which temperature-dependently adheres and cures in a dried state and contains a colophonium resin which is chemically modified and esterified, characterized in that the substance mixture contains an amine of the formula NR¹R²R³ which saponifies the colophonium resin, at least one of the radicals R¹, R² and R³ being the radical of an aliphatic alcohol and the boiling point of the amine being higher than 150°C at a pressure of 10⁵ Pa (1000 mbar).

5. Substance mixture according to Claim 4, characterized in that the amine is selected from a group comprising triethanolamine, triisopropanolamine, diisopropanolamine and diethanolamine.

6. Substance mixture according to Claim 4 or 5, characterized in that the colophonium resin is chemically modified by reaction with a compound selected from a group comprising maleic acid, maleic anhydride and fumaric acid.

7. Substance mixture according to one of Claims 4 to 6, characterized in that the colophonium resin is esterified with an alcohol selected from a group comprising glycerol and pentaerythritol.

8. Substance mixture according to one of Claims 4 to 7, characterized by the following composition:
15 to 20% by weight of chemically modified and esterified colophonium resin;
5 to 10% by weight of triethanolamine;
up to 2% by weight of unionized surfactant;
up to 10% by weight of alcoholic solubilizer;
up to 0.05% by weight of a dyestuff; and
water in an amount making the sum of the amounts specified up to 100% by weight.

## Revendications

1. Procédé de montage et de démontage d'une plaquette semi-conductrice, dans lequel, par un mélange de matériaux entre la plaquette semi-conductrice et une plaque de support, on produit un composé collant et durcissant en fonction de la température, et le mélange de matériaux contient une résine de colophane, qui est chimiquement modifiée et estérifiée, et le composé durci est re-dissous après un polissage de la plaquette semi-conductrice, caractérisé en ce que le composé durci est dissous avec de l'eau et le mélange de matériaux contient une amine de formule NR¹R²R³, qui saponifie la résine de colophane, au moins un des radicaux R¹, R² et R³ étant le radical d'un alcool aliphatique et le point d'ébullition de l'amine à une pression de 10⁵ Pa (1000 mbars) étant supérieur à 150°C.

2. Procédé selon la revendication 1, caractérisé en ce que le mélange de matériaux possède à l'état séché un effet collant qui ne se développe que dans un intervalle de température de 45°C à 85°C.

3. Procédé selon la revendication 1 ou 2, caractérisé en ce que le composé durci est dissous avec de l'eau sans qu'il subsiste de résidus du composé sur la plaque de support ou sur la plaquette semi-conductrice.

4. Mélange de matériaux dissous dans l'eau, qui à l'état séché colle et durcit en fonction de la température, et contient une résine de colophane, qui est chimiquement modifiée et estérifiée, caractérisé en ce que le mélange de matériaux contient une amine de formule NR¹R²R³, qui saponifie la résine de colophane, au moins un des radicaux R¹, R² et R³ étant le radical d'un alcool aliphatique et le point d'ébullition de l'amine à une pression de 10⁵ Pa (1000 mbars) étant supérieur à 150°C.

5. Mélange de matériaux selon la revendication 4, caractérisé en ce que l'amine est choisie dans un groupe qui comprend la triéthanolamine, la triisopropanolamine et la diéthanolamine.

6. Mélange de matériaux selon la revendication 4 ou 5, caractérisé en ce que la résine de colophane est modifiée chimiquement par réaction avec un composé qui est choisi dans un groupe qui comprend l'acide maléique, l'anhydride d'acide maléique et l'acide fumarique.

7. Mélange de matériaux selon l'une quelconque des revendications 4 à 6, caractérisé en ce que la résine de colophane est estérifiée par un alcool qui est choisi dans un groupe comprenant la glycérine et le pentaérythrite.

8. Mélange de matériaux selon l'une quelconque des revendications 4 à 7, caractérisé par la composition suivante :
15% à 20% en poids de résine de colophane chimiquement modifiée et estérifiée;
5% à 10% en poids de triéthanolamine;
jusqu'à 2% en poids d'un agent tensioactif non ionique;
jusqu'à 10% en poids d'un promoteur de dissolution alcoolique;
jusqu'à 0,05% en poids d'un colorant; et
de l'eau en quantité pour compléter la somme des données de quantité à 100% en poids.
